# FASCICULE DE BREVET EUROPEEN

(11) **EP 0 334 419 B1**
(45) Date de publication et mention de la délivrance du brevet: **30.06.1993**
(21) Numéro de dépôt: 89200623.0
(22) Date de dépôt: 13.03.1989
(51) Int. Cl.: G11C 19/28

(54) **Cellule de mémorisation adressable, régistre à décalage et mémoire comportant de telles cellules**
Adressierbare Speicherzelle, Schieberegister und Speicher mit der besagten Zelle
Addressable memory cell, shift register and memory having such cells

(30) Priorité: 18.03.1988 FR 8803540
(43) Date de publication de la demande: 27.09.1989
(73) Titulaire: PHILIPS COMPOSANTS, 92150 Suresnes (FR); Philips Electronics N.V., 5621 BA Eindhoven (NL)
(72) Inventeur: Chantepie, Bernard Société Civile S.P.I.D., F-75008 Paris (FR)
(74) Mandataire: Charpail, François

(56) Documents cités:
- US-A- 3 578 984
- PATENT ABSTRACTS OF JAPAN, vol. 7, no. 208 (E-198)[1353], 14 septembre 1983, page 18 E 198; & JP-A-58 103 222
- PATENT ABSTRACTS OF JAPAN, vol. 11, no. 122 (E-500)[2569], 16 avril 1987; & JP-A-61 269 412
- IEEE JOURNAL OF SOLID-STATE CIRCUITS, vol. SC-18, no. 3, juin 1983, pages 369-376, IEEE, New York, US; M. ROCCHI et al.: "GaAs digital dynamic IC's for applications up to 10 GHz"

## Description

La présente invention concerne une cellule de mémorisation adressable composée, essentiellement, d'un transistor interrupteur à effet de champ et d'une boucle, dite boucle de rafraîchissement, comprenant, notamment, deux inverseurs série. Elle concerne également un registre à décalage et une mémoire comportant de telles cellules de mémorisation adressables.

L'invention trouve une application particulièrement avantageuse dans le domaine des circuits intégrés numériques LSI.

On connaît de l'état de la technique une cellule de mémorisation adressable conforme au préambule, réalisée en technologie MOS (Metal-Oxide-Semi-Conducteur), cf. IEEE Journal of Solid-State Circuits, Vol. SC-18, no.3, juin 1983, p.369-376, Fig 16a. Cette cellule cellule connue est composée, d'une part, d'un transistor interrupteur MOSFET dont la source est reliée à la borne d'entrée de ladite cellule, et dont la grille est reliée à une horloge, et, d'autre part, d'une boucle comprenant, un premier inverseur en série sur le drain dudit transistor interrupteur, un deuxième inverseur en série, le long de la boucle, avec ledit premier inverseur, et un deuxième transistor MOSFET, placé entre la sortie du deuxième inverseur et l'entrée du premier inverseur, et dont la grille est reliée à une horloge complémentaire de celle à laquelle est reliée la grille dudit transistor interrupteur MOSFET. La cellule de mémorisation adressable connue de l'état de la technique comporte donc 2 transistors à effet de champ et nécessite deux horloges.

Le problème technique très général à résoudre lorsque l'on veut réaliser des circuits numériques devant être intégrés à grande échelle (LSI) est de diminuer le nombre de composants des ensembles assurant une fonction donnée, comme, par exemple, les cellules de mémorisation adressables ainsi que les registres à décalage et les mémoires comportant de telles cellules de mémorisation. D'autre part, c'est également un souci constant que de chercher à réduire la consommation des circuits. Enfin, ces résultats doivent, de préférence, être obtenus sans altération des performances, et, en particulier de la dynamique.

Aussi, le problème technique à résoudre par l'objet de la présente demande est de proposer une cellule de mémorisation adressable, composée, d'une part, d'un transistor interrupteur à effet de champ dont la source est reliée à la borne d'entrée de ladite cellule, et dont la grille est reliée à une horloge, et, d'autre part, d'une boucle comprenant, un premier inverseur en série sur le drain dudit transistor interrupteur et dont la sortie est reliée à la borne de sortie de la cellule, et un deuxième inverseur en série, le long de la boucle, avec ledit premier inverseur, ladite cellule étant réalisée en arséniure de Gallium, cellule qui serait formée d'un nombre de transistors moins grand, et dont la consommation serait plus faible, tout en présentant une fréquence de fonctionnement élevée, avec l'avantage substantiel que ces économies de composants et d'énergie représentent lorsque de nombreuses cellules de mémorisation sont associées dans des registres à décalage ou dans des mémoires.

La solution au problème technique posé consiste, selon la présente invention, en ce que, la boucle comporte également une diode placée dans le sens conducteur entre la borne de sortie et l'entrée du deuxième inverseur, et une résistance placée entre la sortie du deuxième inverseur et l'entrée du premier inverseur.

Ainsi, on constate que, par rapport à la cellule de mémorisation connue de l'état de la technique, le transistor interrupteur présent dans la boucle a été supprimé, ce qui ramène le nombre de transistors par cellule à 1. D'autre part, la diminution du nombre de transistors ajoutée à l'utilisation de l'arséniure de gallium contribue à une réduction notable de la consommation. Enfin, la boucle, dite aussi boucle de rafraîchissement, étant toujours présente, aucune limitation en fréquence n'a été introduite. Comme on le verra en détail plus loin, l'effet technique produit par la cellule selon l'invention consiste essentiellement en ce que la présence d'une diode dans la boucle permet de relever la tension de sortie de la cellule en compensant la diminution de niveau introduit par le transistor MESFET du premier inverseur, qui, en technologie GaAs, comporte une diode intrinsèque dans laquelle se décharge partiellement la capacité intrinsèque Cgs qui fixe le niveau d'entrée de la cellule.

La cellule de mémorisation adressable conforme à l'invention offre également d'autres avantages. En particulier, elle présente un fonctionnement insensible aux variations technologiques du fait de la réaction relativement importante introduite par la boucle. D'autre part, on verra que la diode de la boucle participe à un circuit capacitif susceptible d'absorber les signaux transitoires émis par les horloges.

Enfin, le niveau de sortie des cellules étant maintenu, on peut envisager de les grouper les unes avec les autres. C'est ainsi qu'il est possible de réaliser un registre à décalage comportant N cellules de mémorisation adressables conformes à l'invention, placées en série, et tel que les signaux d'horloge appliqués aux transistors interrupteurs sont alternativement H et H̅, de façon à former des couples cellule maître-esclave. De la même manière, on peut constituer une mémoire comportant M registres à décalage selon l'invention dont les cellules de mémorisation adressables sont reliées à un bus chacune par l'intermédiaire d'un transistor interrupteur d'adressage. Dans ce cas, et afin notamment d'augmenter la rapidité de la mémoire, il est prévu que la sortie de la diode et la sortie du deuxième inverseur de la boucle de chaque cellule de mémorisation adressable sont respectivement reliées à la grille de deux transistors à effet de champ en série formant un push-pull dont le point milieu est relié à la source du transistor interrupteur d'adressage. Cette disposition a également l'avantage que le push-pull absorbe les signaux transitoires dus au transistor d'adressage.

La description qui va suivre en regard des dessins annexés, donnés à titre d'exemples non limitatifs, fera bien comprendre en quoi consiste l'invention et comment elle peut être réalisée.

La figure 1 est le schéma d'une cellule de mémorisation adressable conforme à l'invention.

La figure 2 donne le schéma d'une cellule maître-esclave d'un registre à décalage selon l'invention.

La figure 3 est le schéma d'une mémoire adressable conforme à l'invention.

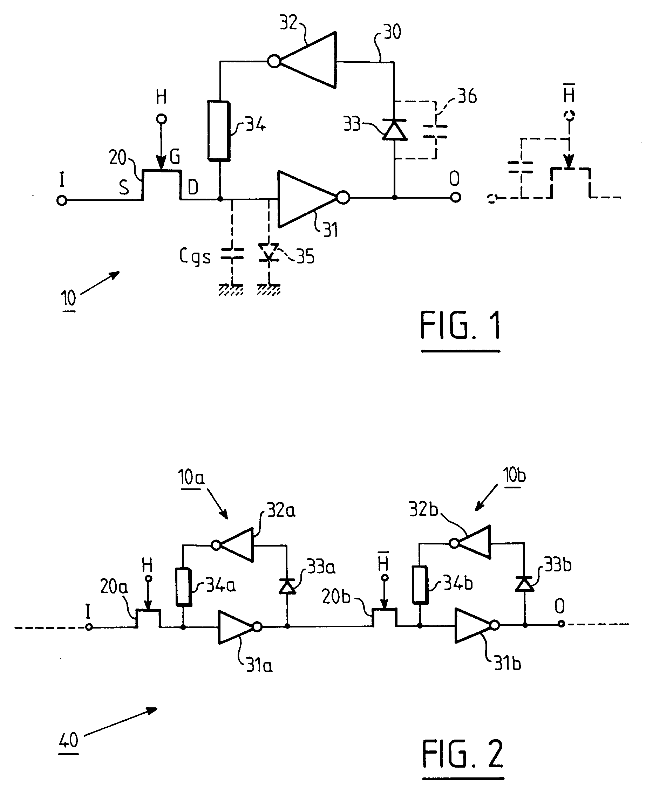

Le schéma de la figure 1 montre une cellule 10 de mémorisation adressable composée, d'une part, d'un transistor interrupteur 20 à effet de champ, en arséniure de gallium du type MESFET. La source S du transistor 20 est reliée à la borne d'entrée I de la cellule 10, tandis que la grille G est reliée à une horloge H. D'autre part, la cellule 10 est également composée d'une boucle 30 réalisée sur substrat de GaAs, comprenant, un premier inverseur 31 en série sur le drain D du transistor interrupteur 20 et dont la sortie est reliée à la borne de sortie 0 de la cellule 10, et un deuxième inverseur 32 en série, le long de la boucle 30, avec ledit premier inverseur 31. Comme on peut le voir sur la figure 1, la boucle 30 comporte aussi une diode 33 placée dans le sens conducteur entre la sortie du premier inverseur 31 et l'entrée du deuxième inverseur 32, et une résistance 34 placée entre la sortie du deuxième inverseur 32 et l'entrée du premier inverseur 31.

Lorsque le niveau de l'horloge H est à 1, et que l'entrée I est à 1, la capacité intrinsèque Cgs du transistor MESFET du premier inverseur 31 se charge jusqu'à une valeur limitée à environ 0,7V imposée par la diode intrinsèque 35 présente à l'entrée de tous les transistors MESFET réalisés sur arséniure de gallium. On voit sur la figure 1 qu'en l'absence de la boucle 30, le passage à 0 du niveau d'horloge provoquerait la décharge partielle de Cgs dans la diode 35. Le niveau d'entrée en D serait alors de l'ordre de 0,4V, ce qui est insuffisant compte tenu du bruit pour distinguer entre un niveau logique 0 ou un niveau logique 1. Par contre, la boucle 30 telle qu'elle est représentée sur la figure 1 permet de maintenir la tension d'entrée au point 0 à 0,7V. En effet, la présence de la boucle de réaction permet, par un dimensionnement convenable, de fournir le courant continu nécessaire à la diode 35 et de maintenir la tension à 0,7V environ. Par ailleurs, on peut remarquer sur la figure 1 que la diode 33 présente en parallèle une capacité intrinsèque 36, laquelle est couplée à la capacité grille-source du transistor interrupteur de la cellule suivante, dessiné en pointillé. Le circuit capacitif ainsi formé permet d'absorber les signaux transitoires émis lors des changements de niveau de l'horloge H̅ et donc de protéger le premier inverseur 31.

La figure 2 montre un registre 40 à décalage comportant N cellules 10a, 10b de mémorisation adressables du type de celle représentée sur la figure 1. Les signaux d'horloge appliqués aux transistors sont alternativement H et H̅, la cellule d'horloge H étant la cellule-maître 10a et la cellule d'horloge H̅ la cellule-esclave 10b.

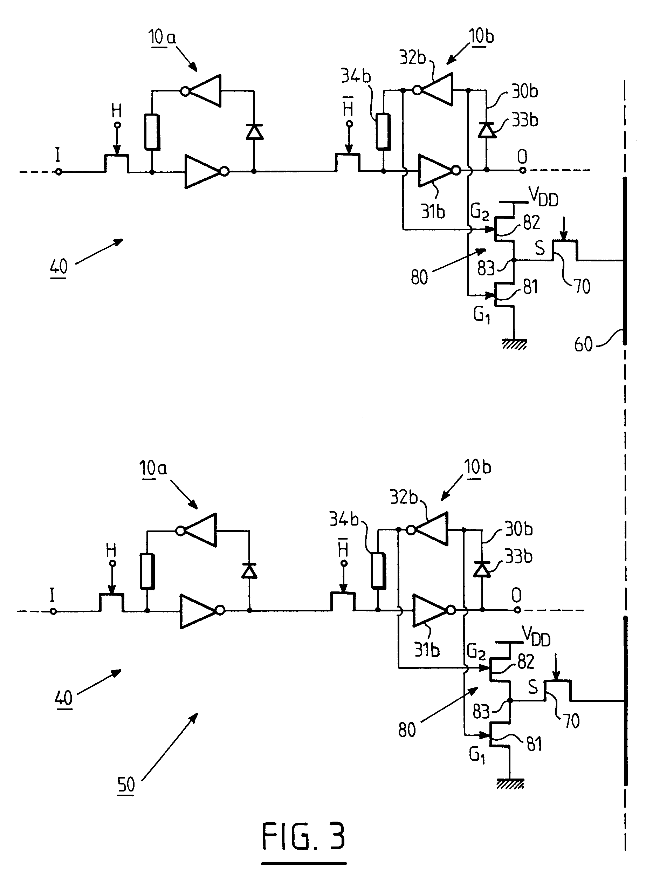

Le schéma de la figure 3 est celui d'une mémoire 50 comportant M registres 40 à décalage analogues à celui de la figure 2, et dont les cellules esclaves 10b sont reliées à un bus 60 par l'intermédiaire d'un transistor interrupteur 70 d'adressage. Il serait possible de connecter directement le transistor 70 à la sortie 0 de la cellule 10b. Toutefois, cette disposition aurait l'inconvénient de limiter la vitesse de la mémoire à celle de la charge de la capacité grille-source du transistor d'adressage. D'autre part, la présence de ce transistor provoquerait d'autres signaux transitoires s'ajoutant à ceux produits par les horloges.

Aussi, comme on peut le voir sur la figure 3, la sortie de la diode 33b et la sortie du deuxième inverseur 32b de la boucle 30b de chaque cellule esclave 10b sont respectivement reliées à la grille G1 et à la grille G2 de deux transistors 81, 82 à effet de champ en série formant un push-pull 80 dont le point milieu 83 est relié à la source du transistor interrupteur 70 d'adressage.

En effet, la plus faible impédance de sortie du push-pull permet d'absorber plus rapidement les signaux transitoires de commutation.

Le circuit de la figure 3 permet alors d'éviter que la charge de la capacité du transistor 70 se produise à la sortie 0, ce point n'est donc pas ralenti. Par ailleurs, les signaux transitoires dus au transistor 70 d'adressage sont isolés par le push-pull 80 et ne pertubent pas le fonctionnement du registre à décalage 40.

Cette disposition permet en outre de relier N cellules identiques à un seul bus de sortie comme dans le cas d'une mémoire statique classique, le transistor interrupteur 70 présentant une haute impédance lorsqu'il est pincé.

## Revendications

1. Cellule (10) de mémorisation adressable, composée, d'une part, d'un transistor interrupteur (20) à effet de champ dont la source (S) est reliée à la borne d'entrée (I) de ladite cellule (10), et dont la grille (G) est reliée à une horloge (H,H̅), et, d'autre part, d'une boucle (30) comprenant, un premier inverseur (31) en série sur le drain (D) dudit transistor interrupteur (20) et dont la sortie est reliée à la borne de sortie (0) de la cellule (10), et un deuxième inverseur (32) en série, le long de la boucle (30), avec ledit premier inverseur (31), ladite cellule (10) étant réalisée en arséniure de gallium, caractérisée en ce que, la boucle (30) comporte également une diode (33) placée dans le sens conducteur entre la borne de sortie (0) et l'entrée du deuxième inverseur (32), et une résistance (34) placée entre la sortie du deuxième inverseur (32) et l'entrée du premier inverseur (31).

2. Registre (40) à décalage comportant N cellules de mémorisation adressables placées en série, caractérisé en ce que lesdites N cellules (10a,10b) de mémorisation adressables sont conformes à la revendication 1, les signaux d'horloge appliqués aux transistors interrupteurs (20a,20b) étant alternativement H et H̅ de façon à former des couples cellule maître (10a)-cellule esclave (10b).

3. Mémoire (50) comportant M registres à décalage dont les cellules esclaves (10b) de mémorisation adressables sont reliées à un bus (60) chacune par l'intermédiaire d'un transistor interrupteur (70) d'adressage, caractérisé en ce que, lesdits M registres (40) à décalage étant conformes à la revendication 2, la sortie de la diode (33b) et la sortie du deuxième inverseur (32b) de la boucle (30b) de chaque cellule esclave (10b) de mémorisation adressable sont respectivement reliées à la grille (G1) et à la grille (G2) de deux transistors (81,82) à effet de champ en série formant un push-pull (80) dont le point milieu (83) est relié à la source du transistor interrupteur (70) d'adressage.

## Claims

1. An addressable memory cell (10) which consists on the one hand of an interrupt field effect transistor (20) whose source (S) is connected to the input terminal (I) of said cell (10) and whose gate (G) is connected to a clock (H, H̅), and on the other hand of a loop (30) which comprises a first inverter (31) which is connected in series with the drain (D) of said interrupt transistor (20) and whose output is connected to the output terminal (0) of the cell (10), and a second inverter (32) which is connected in series, along said loop (30), with said first inverter (31), said cell (10) being realized in gallium arsenide, characterized in that the loop (30) also comprises a diode (33) which is disposed in the forward direction between the output terminal (0) and the input of the second inverter (32), and a resistance (34) which is disposed between the output of the second inverter (32) and the input of the first inverter (31).

2. A shift register (40), comprising N series-connected addressable memory cells, characterized in that said N addressable memory cells (10a, 10b) are as claimed in Claim 1, the clock signals applied to the interrupt transistors (20a, 20b) being alternately H and H̅ so as to form pairs of master (10a) and slave (10b) cells.

3. A memory (50), comprising M shift registers whose slave addressable memory cells (10b) are connected to a bus (60) via a respective addressing interrupt transistor (70), characterized in that said M shift registers (40) are as claimed in Claim 2, the output of the diode (33b) and the output of the second inverter (32b) of the loop (30b) of each slave addressable memory cell (10b) being connected to the gate (G1) and the gate (G2), respectively, of two series-connected field effect transistors (81, 82) which form a push-pull stage (80) whose centre point (83) is connected to the source of the addressing interrupt transistor (70)

## Patentansprüche

1. Adressierbare Speicherzelle (10), die einerseits einen Feldeffekt-Schalttransistor (20), dessen Source (S) mit der Eingangsklemme (I) der Zelle (10) und dessen Gate (G) mit einem Taktgeber (H,H̅) verbunden sind, und andererseits eine Schleife (30) enthält, die eine reihengeschaltete erste Umkehrstufe (31) an der Drain (D) des Schalttransistors (20), und dessen Ausgang mit der Ausgangsklemme (0) der Zelle (10) verbunden ist, und eine zweite Umkehrstufe (32) auf der Schleife (30) in Reihenschaltung mit der ersten Umkehrstufe (31) enthalt, wobei die Zelle (10) aus Galliumarsenid besteht,
dadurch gekennzeichnet, daß die Schleife (30) ebenfalls zwischen der Ausgangsklemme (0) und dem Eingang der zweiten Umkehrstufe (32) eine in der Leitrichtung angeordnete Diode (33) und einen zwischen dem Ausgang der zweiten Umkehrstufe (32) und dem Eingang der ersten Umkehrstufe (31) angeordneten Widerstand (34) enthält.

2. Schieberegister (40) mit H adressierbaren Speicherzellen in Reihenschaltung, dadurch gekennzeichnet, daß die N adressierbaren Speicherzellen (10a, 10b) dem Anspruch 1 entsprechen, wobei die den Schalttransistoren (20a, 20b) zugeführten Taktsignale abwechselnd H und H̅ sind, um Meister-(10a)-Sklaven-(10b)-Zellenpaare zu bilden.

3. Speicher (50) mit M Schieberegistern, deren adressierbare Sklaven-Speicherzellen (10b) jeweils mit einem Bus (60) über einen Adreß-Schalttransistor (70) verbunden sind, dadurch gekennzeichnet, daß die M Schieberegister (40) dem Anspruch 2 entsprechen, wobei der Ausgang der Diode (33b) bzw. der Ausgang der zweiten Umkehrstufe (32) der Schleife (30b) jeder adressierbaren Sklaven-Speicherzelle (10b) mit dem Gate (G1) und mit dem Gate (G2) von zwei Feldeffekttransistoren (81, 82) in Reihenschaltung verbunden sind, die eine Gegentaktschaltung (80) bilden, deren Knotenpunkt (83) mit der Source des Adreß-Schalttransistors (70) verbunden ist.
